Europäisches Patentamt

European Patent Office

Office européen des brevets

(19)

(11) Numéro de publication : **0 032 094 B1**

# FASCICULE DE BREVET EUROPÉEN

(12)

(45) Date de publication du fascicule du brevet :
28.12.83

(21) Numéro de dépôt : 80401862.0

(22) Date de dépôt : 24.12.80

(51) Int. Cl.³ : **H 03 K 4/72, H 03 K 4/83, H 04 N 3/18, H 02 P 13/24**

(54) **Circuit de conversion d'une tension alternative en une tension à fréquence inférieure, notamment pour l'alimentation du déviateur vertical d'un téléviseur.**

(30) Priorité : 08.01.80 FR 8000307

(43) Date de publication de la demande :
15.07.81 Bulletin 81/28

(45) Mention de la délivrance du brevet :
28.12.83 Bulletin 83/52

(84) Etats contractants désignés :
DE GB IT NL

(56) Documents cités :
EP-A- 0 007 866
FR-A- 2 262 442
FR-A- 2 318 545
GB-A- 1 214 313
US-A- 3 870 903
FUNKSCHAU, vol. 42, no. 18, septembre 1970, page 1840, Münich, DE. E. RICHTER: "Netzgerät mit Thyristor"
Le dossier contient des informations techniques présentées postérieurement au dépôt de la demande et ne figurant pas dans le présent fascicule.

(73) Titulaire : **THOMSON-BRANDT**
**173, Boulevard Haussmann**
**F-75379 Paris Cedex 08 (FR)**

(72) Inventeur : **Colineau, Joseph**
**THOMSON-CSF SCPI 173, Bld Haussmann**
**F-75360 Paris Cedex 08 (FR)**
Inventeur : **Maheo, Jean-Yves**
**THOMSON-CSF SCPI 173, Bld Haussmann**
**F-75360 Paris Cedex 08 (FR)**

(74) Mandataire : **Grynwald, Albert et al**
**THOMSON-CSF SCPI 173, Bld Haussmann**
**F-75379 Paris Cedex 08 (FR)**

Jouve, 18, rue St-Denis, 75001 Paris, France

Circuit de conversion d'une tension alternative en une tension à fréquence inférieure, notamment pour l'alimentation du déviateur vertical d'un téléviseur

L'invention est relative à un circuit de conversion d'une tension alternative en une tension variable à fréquence inférieure qui comprend un interrupteur commandé pour qu'à chaque période de la tension alternative il soit conducteur pendant un temps qui est fonction de la tension de sortie désirée, une branche de contre-réaction étant prévue pour asservir la tension de sortie à une consigne.

Un tel circuit de conversion, appelé circuit en mode commuté ou alimentation à découpage, ne consomme que l'énergie juste nécessaire pour alimenter une charge utilisant la tension de sortie. C'est pourquoi il peut se prêter à de nombreuses applications.

On a décrit dans la demande de brevet européen EP-A-7866 au nom de la demanderesse un tel circuit constituant une alimentation auxiliaire pour un récepteur de télévision, la tension alternative étant une tension à la fréquence de balayage horizontal et la tension de sortie une tension continue.

Dans la demande de brevet européen EP-A-8263, également au nom de la demanderesse, on a décrit un autre circuit de ce type dans lequel la tension de sortie est utilisée pour alimenter la bobine de déviation verticale d'un récepteur de télévision, la tension alternative d'entrée étant aussi une tension à la fréquence de balayage horizontal. Les documents mentionnés appartiennent à l'état de la technique visé à l'article 5413).

L'invention englobe le même domaine d'application mais n'est cependant pas limitée à celui-ci. Elle se rapporte, de façon générale, aux alimentations en tension, par exemple pour des moteurs ou pour constituer des amplificateurs audio fréquence ou, en télévision, pour constituer un circuit de correction de la distorsion de coussin Est-Ouest.

L'invention résulte de la constatation que dans les circuits des demandes de brevet antérieures mentionnées ci-dessus le temps de réponse de l'asservissement à une perturbation pouvait être trop long pour certaines applications. En effet, la limite inférieure du temps de réponse est déterminée par les moyens de filtrage faisant partie du circuit de conversion car le signal de mesure de l'asservissement est la tension de sortie du circuit qui, bien entendu, apparaît en aval de ces moyens de filtrage alors que la branche de contre-réaction agit sur l'électrode de commande de l'interrupteur qui se trouve en amont des moyens de filtrage.

L'invention assure, au contraire, une réponse rapide de l'asservissement à une perturbation.

Le circuit selon l'invention est donc un circuit de conversion d'une tension alternative à valeur moyenne nulle en une tension continue ou variable à une fréquence inférieure qui comprend : un moyen de filtrage, un interrupteur commandé de manière qu'à chaque période de la tension alternative d'entrée il soit conducteur pendant un temps qui est fonction de la tension de sortie désirée, et qui est déposé en amont du moyen de filtrage, et un asservissement de la tension de sortie à une consigne agissant sur la commande de l'interrupteur. Ce circuit est caractérisé en ce que le signal de mesure de l'asservissement est la valeur moyenne de la tension aux bornes de l'interrupteur au cours d'une période de la tension alternative d'entrée. En effet cette tension moyenne représente la tension de sortie et peut donc être utilisée pour constituer le signal de mesure de l'asservissement. Le temps de réponse de cet asservissement à une perturbation est au maximum de l'ordre d'une période du signal d'entrée alors que dans les circuits des demandes de brevet antérieures ce temps de réponse est de l'ordre d'une période du signal de sortie. En outre le circuit selon l'invention est d'une réalisation particulièrement simple.

D'autres caractéristiques et avantages de l'invention apparaîtront avec la description de certains de ses modes de réalisation, celle-ci étant effectuée en se référant aux dessins ci-annexés sur lesquels :

la figure 1 est un schéma d'un circuit de balayage vertical selon l'invention, et

les figures 2 à 5 sont des variantes de la figure 1.

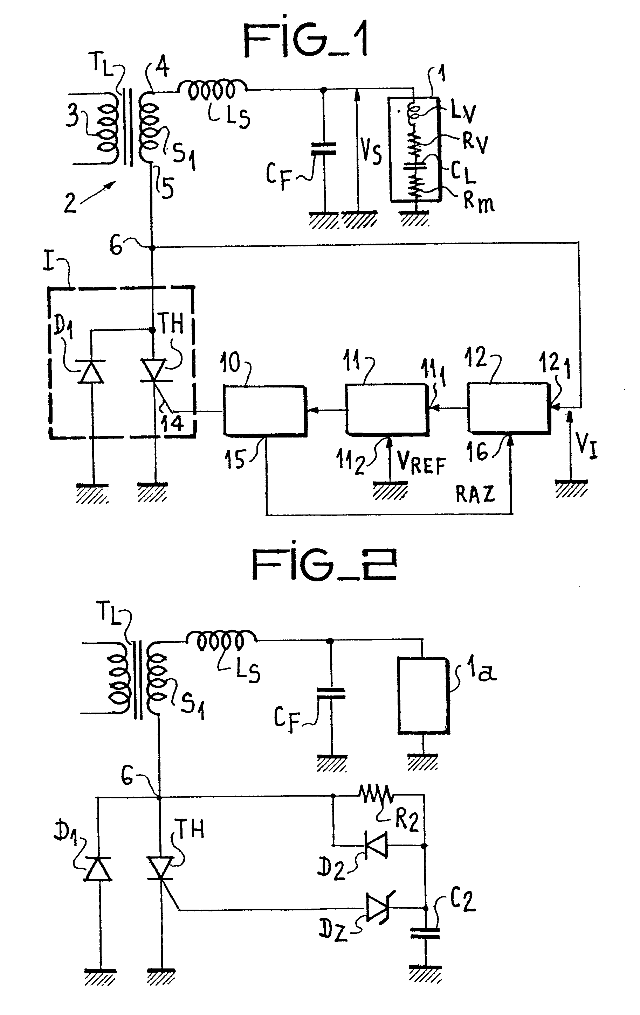

Le circuit de balayage vertical (Fig. 1) comporte une bobine de déviation verticale représentée ici par une inductance $L_V$ en série avec une résistance $R_V$, cette bobine étant elle-même en série avec un condensateur de liaison $C_L$ et résistance de mesure $R_m$. Cet ensemble en série $L_V$, $R_V$, $C_L$ et $R_m$ constitue une charge 1 branchée aux bornes de sortie d'une alimentation à découpage 2 qui tire son énergie des impulsions de retour-ligne, c'est-à-dire de la surtension apparaissant aux bornes de la bobine de déviation horizontale (non montrée) lors des périodes de retour de balayage horizontal.

Ces impulsions de retour-ligne sont appliquées aux bornes de l'enroulement primaire 3 d'un transformateur $T_L$ et sont recueillies aux bornes d'un enroulement secondaire $S_1$ de ce transformateur alimentant, d'une part, des moyens de filtrage à inductance $L_S$ (non couplée au transformateur) et condensateur de filtrage $C_F$ et, d'autre part, un interrupteur commandé I composé ici d'un thyristor TH en parallèle mais en sens inverse avec une diode $D_1$.

Le montage est tel qu'une borne de l'inductance $L_S$ est connectée directement à une première borne 4 de l'enroulement $S_1$, l'autre borne de l'inductance étant reliée à la masse par l'intermédiaire du condensateur $C_F$. La seconde borne 5 de l'enroulement $S_1$ est connectée à l'anode du thyristor TH dont la cathode est à la masse, l'anode de la diode $D_1$ étant ainsi également à la masse.

La charge 1 est aux bornes du condensateur $C_F$.

Selon l'invention la tension $V_1$ aux bornes de l'interrupteur I est appliquée à l'entrée $12_1$ d'un intégrateur 12 grâce à une connexion 13 entre la borne 6 commune à l'enroulement $S_1$ à cet interrupteur I. La sortie de cet intégrateur est reliée à la première entrée $11_1$ d'un comparateur dont la seconde entrée $11_2$ reçoit un signal $V_{REF}$ de consigne représentant la tension désirée aux bornes de la charge 1. Ce signal est fourni par un oscillateur de balayage vertical ou « oscillateur trame » (non représenté) engendrant des signaux sensiblement en dents de scie à la fréquence de balayage vertical. La sortie du comparateur 11 est reliée à la gâchette 14 du thyristor TH par l'intermédiaire d'un élément de mise en forme 10 présentant une borne 15 reliée à une entrée 16 de remise à zéro RAZ de l'intégrateur 12 à chaque période de balayage d'une ligne.

La valeur moyenne $V_1$ sur une période du signal de balayage ligne de la tension aux bornes de l'interrupteur I est égale à la valeur moyenne, sur cette même période, de la tension de sortie $V_S$ car les valeurs moyennes respectives des tensions aux bornes de l'enroulement $S_1$ et aux bornes de l'enroulement $L_S$ sont nulles.

Le thyristor TH devient conducteur quand le niveau du signal de sortie de l'intégrateur 12 atteint le niveau du signal de référence $V_{REF}$. La tension de sortie $V_S$ est ainsi l'image de la tension de consigne $V_{REF}$.

Pour que l'intégration se fasse dans les mêmes conditions à chaque période du signal d'entrée l'intégrateur est remis à zéro grâce au circuit 10 à chaque période dudit signal d'entrée, c'est-à-dire à chaque période de balayage horizontal.

Dans la réalisation représentée sur la figure 1 l'intégration et la comparaison sont effectuées sous forme analogique. En variante ces fonctions sont effectuées de manière numérique.

En variante encore, la tension $V_{REF}$ au lieu d'être variable est une tension continue, la tension de sortie étant alors également une tension continue $V_S$, ce qui permet d'utiliser le circuit pour constituer une alimentation auxiliaire dans un récepteur de télévision.

La tension $V_S$ est indépendante de la forme, de l'amplitude et de la fréquence du signal d'entrée tant que la fréquence de ce signal est grande devant la fréquence du signal de consigne $V_{REF}$.

Le circuit est autoprotégé et son impédance de sortie est faible.

Enfin, comme on l'a déjà mentionné, l'asservissement est très rapide, son temps de réponse étant de l'ordre d'une période de signal de balayage ligne.

Le circuit représenté sur la figure 2 est destiné à engendrer une tension continue aux bornes de la charge $1_a$.

L'intégrateur comporte une résistance $R_2$ en série avec un condensateur $C_2$ dont une armature est à la masse.

Une diode $D_2$ est en parallèle sur la résistance $R_2$, son anode étant reliée au point de jonction de la résistance $R_2$ au condensateur $C_2$ et sa cathode étant reliée à la borne 6. Cette diode $D_2$ permet la décharge du condensateur $C_2$ lorsque le thyristor TH est conducteur et ainsi la remise à zéro de l'intégrateur.

La gâchette du thyristor TH est connectée à l'anode d'une diode Zener $D_Z$ dont la cathode est connectée au point de jonction résistance $R_2$-condensateur $C_2$. Cette diode Zener constitue à la fois le comparateur 11 et le générateur de la tension de consigne $V_{REF}$.

Lorsque la tension aux bornes du condensateur $C_2$ dépasse la tension Zener de la diode $D_Z$ un courant circule dans cette diode, ce qui provoque le passage à l'état conducteur du thyristor TH. La tension Zener détermine donc l'instant de déclenchement du thyristor à chaque période du signal d'entrée et donc le niveau du signal de sortie.

En variante à la place d'une diode Zener $D_Z$ on utilise un diac (non représenté).

Le circuit représenté sur la figure 2 ne nécessite aucune alimentation extérieure et peut être réalisé sous forme de circuit intégré monolithique ou hybride et se présente alors sous forme d'un dipôle.

A partir d'une seule source de signaux périodiques, c'est-à-dire à partir d'un seul enroulement $S_1$, on peut obtenir plusieurs tensions à l'aide de plusieurs dipôles de ce type, chacun étant associé à une cellule de filtrage $L_S$, $C_F$ et à une charge 1.

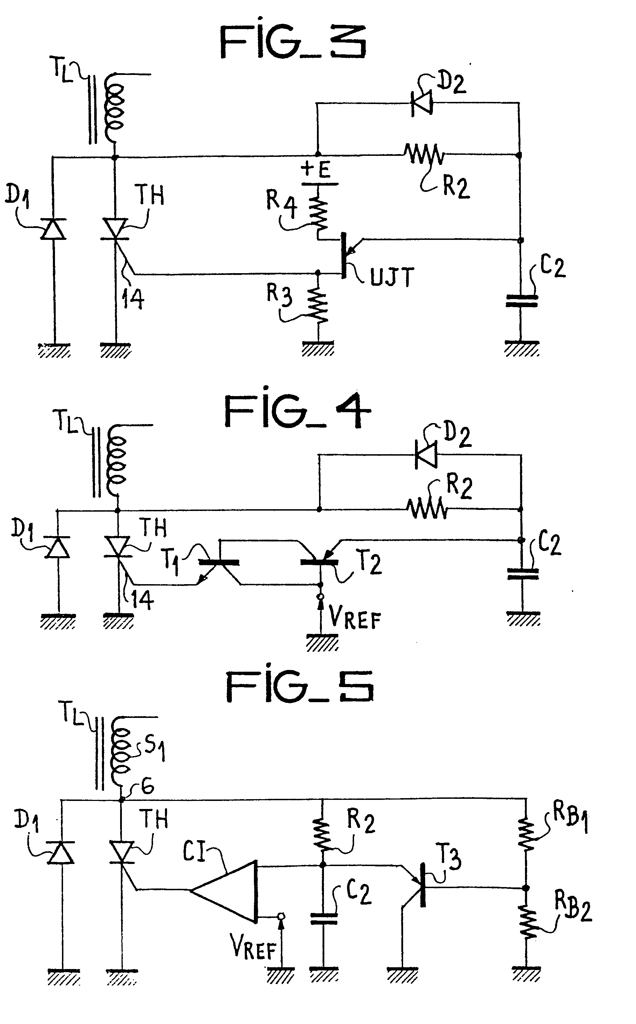

Dans la réalisation représentée sur la figure 3 à la place d'une diode Zener $D_Z$ on prévoit un transistor unijonction UJT polarisé à l'aide de résistance $R_3$ et $R_4$ par une tension continue d'alimentation + E constituant la source de référence ou source de consigne.

L'émetteur du transistor unijonction est relié au point commun à la résistance $R_2$ et au condensateur $C_2$, sa première base est reliée à la gâchette 14 du thyristor TH ainsi qu'à la masse par l'intermédiaire de la résistance $R_3$, et sa seconde base est connectée à la source de référence + E par l'intermédiaire de la résistance $R_4$.

Cette réalisation présente l'avantage de permettre l'injection d'une énergie importante sur la gâchette du thyristor 14 au moment de son amorçage. Comme dans le cas de la figure 2, on peut faire varier l'instant de déclenchement de l'interrupteur actif, et donc la tension continue de sortie, en faisant varier la valeur de la résistance $R_2$ et/ou la capacité du condensateur $C_2$. On peut donc utiliser une résistance variable et/ou un condensateur à capacité variable. Il est cependant préférable de limiter les variations de ces valeurs de manière telle que le produit de la valeur de la résistance $R_2$ par la capacité du condensateur $C_2$ reste grande devant la période du signal d'entrée, afin que le signal fourni par l'intégrateur varie linéairement en fonction du temps.

L'exemple de la figure 4 est plus spécialement adapté à la réalisation d'un circuit engendrant une tension variable. Dans ce circuit on prévoit, à la place la diode Zener $D_Z$ ou du transistor unijonction UJT, deux transistors $T_1$ et $T_2$. Le transistor $T_1$ est du type NPN avec son émetteur relié à la gâchette 14 du thyristor TH, son collecteur relié à la base du transistor $T_2$ et sa base connectée au collecteur du même transistor $T_2$. Ce dernier est du type PNP avec son émetteur relié au point commun à la résistance $R_2$ et au condensateur $C_2$. La tension de référence $V_{REF}$ est appliquée sur la base du transistor $T_2$.

L'ensemble des deux transistors $T_1$ et $T_2$ compare la tension aux bornes du condensateur $C_2$ à la tension de référence $V_{REF}$. Ces deux transistors sont conducteurs dès que ces tensions sont égales. La tension $V_{REF}$ est par exemple, comme dans le cas de la figure 1, un signal sensiblement en dents de scie à la fréquence de balayage vertical, la charge 1 étant alors la même que celle représentée sur la figure 1.

Dans l'exemple de la figure 5 l'intégrateur comporte également une résistance $R_2$ et un condensateur $C_2$. Mais à la place de la diode $D_2$ on prévoit un transistor $T_3$ du type PNP dont l'émetteur est relié au point commun à la résistance $R_2$ et au condensateur $C_2$ et dont le collecteur est à la masse. La base de ce transistor $T_3$ est relié au point commun 6 à l'anode du thyristor TH et à l'enroulement $S_1$ du transistor ligne $T_L$ par l'intermédiaire d'une résistance $R_{B1}$. Cette base est également reliée à la masse par l'intermédiaire d'une autre résistance $R_{B2}$.

Le comparateur est un circuit intégré CI dont la sortie est directement reliée à la gâchette du thyristor TH.

Le signal de sortie du comparateur CI change de niveau lorsque la tension aux bornes du condensateur $C_2$ atteint la tension de référence $V_{REF}$, ce qui provoque la conduction du thyristor TH. La tension aux bornes de l'interrupteur devient alors nulle et le transistor $T_3$ passe à l'état conducteur, ce qui entraîne la décharge du condensateur $C_2$. La tension aux bornes du condensateur $C_2$ reste nulle tant que l'interrupteur est fermé, c'est-à-dire tant que le thyristor est conducteur.

La tension de référence $V_{REF}$ est, comme dans le cas de la figure 4, soit une tension variable soit une tension constante.

Quelque soit le mode de réalisation, le montage permet de transformer une énergie se présentant sous la forme d'un signal alternatif, délivré par un générateur ou prélevé sur un enroulement de transformateur, en une énergie ayant la forme continue ou variable à fréquence inférieure.

## Revendications

1. Circuit électrique de conversion d'une tension alternative à valeur moyenne nulle en une tension continue ou variable à une fréquence inférieure comprenant : un moyen de filtrage ($L_S$, $C_F$), un interrupteur (I) commandé de manière qu'à chaque période de la tension alternative d'entrée il soit conducteur pendant un temps qui est fonction de la tension de sortie désirée ($V_S$) et qui est disposé en amont du moyen de filtrage ($L_S$, $C_F$), et un asservissement de la tension de sortie à une consigne ($V_{REF}$) agissant sur la commande de l'interrupteur, caractérisé en ce que le signal de mesure ($II_1$) de l'asservissement est la valeur moyenne de la tension aux bornes de l'interrupteur (I) au cours d'une période de la tension alternative d'entrée.

2. Circuit selon la revendication 1, caractérisé en ce que le moyen de filtrage est non dissipatif et comporte une inductance ($L_S$) et un condensateur ($C_F$), la tension de sortie étant la tension aux bornes de ce condensateur.

3. Circuit selon la revendication 1 ou 2, caractérisé en ce que pour établir la valeur moyenne, il comporte un intégrateur (12) dont l'entrée reçoit le signal de tension aux bornes de l'interrupteur commande (1).

4. Circuit selon la revendication 3, caractérisé en ce qu'il comporte un comparateur (11) pour comparer le signal de sortie de l'intégrateur (12) au signal de consigne ($V_{REF}$) et pour commander l'interrupteur (1) en fonction du résultat de la comparaison.

5. Circuit selon la revendication 3 ou 4, caractérisé en ce que l'intégrateur est remis à zéro à chaque période de la tension alternative.

6. Circuit selon les revendications 4 et 5, caractérisé en ce que la sortie du comparateur (11) est reliée à l'électrode de commande de l'interrupteur (I) par l'intermédiaire d'un circuit de mise en forme (10) comportant une sortie reliée à l'entrée de remise à zéro (RAZ) de l'intégrateur (12).

7. Circuit selon l'une quelconque des revendications 3 à 6, caractérisé en ce que l'intégrateur comporte une résistance ($R_2$) en série avec un condensateur ($C_2$), le signal de sortie de cet intégrateur étant constitué par la tension aux bornes du condensateur.

8. Circuit selon les revendications 5 et 7, caractérisé en ce qu'une diode ($D_2$) est en parallèle sur la résistance ($R_2$) de l'intégrateur de manière à décharger le condensateur ($C_2$) à chaque période de la tension alternative, lorsque l'interrupteur (TH) est conducteur.

9. Circuit selon la revendication 4, caractérisé en ce que, la tension de consigne étant constante, le comparateur comprend une diode Zener ($D_Z$) ou un diac dont la tension caractéristique représente la tension de sortie désirée.

10. Circuit selon les revendications 7 et 9, caractérisé en ce que la diode ($D_Z$) est connectée entre une armature du condensateur ($C_2$) de l'intégrateur et l'électrode de commande de l'interrupteur (TH).

11. Circuit selon les revendications 4 et 7, caractérisé en ce que le comparateur comporte un transistor uni-jonction (UJT) dont l'émetteur reçoit la tension aux bornes du condensateur ($C_2$) de l'intégrateur et dont une base reçoit la tension (E) de consigne.

12. Circuit selon les revendications 4 et 7, caractérisé en ce que le comparateur comporte un transistor ($T_2$) dont une électrode reçoit la tension aux bornes du condensateur ($C_2$) de l'intégrateur et une autre électrode reçoit le signal ($V_{REF}$) de consigne.

13. Circuit selon les revendications 5 et 7, caractérisé en ce qu'il comprend un transistor ($T_3$) dont l'espace émetteur-collecteur est en parallèle sur le condensateur ($C_2$) de l'intégrateur et qui est monté pour être conducteur lorsque l'interrupteur commandé (TH) est lui-même conducteur de manière à décharger ledit condensateur à chaque période de la tension alternative.

14. Circuit selon l'une quelconque des revendications précédentes, caractérisé en ce que l'interrupteur commandé (1) comporte un thyristor (TH) en parallèle mais en sens inverse avec une diode ($D_1$).

15. Circuit selon l'une quelconque des revendications précédentes, caractérisé en ce que la tension alternative est une tension à la fréquence de balayage horizontal dans un récepteur de télévision.

16. Circuit selon la revendication 15, caractérisé en ce que la tension alternative est la tension de retour ligne.

17. Circuit selon la revendication 15 ou 16, caractérisé en ce que la tension de sortie est continue et alimente des circuits auxiliaires d'un récepteur de télévision.

18. Circuit selon la revendication 16, caractérisé en ce que la tension de sortie constitue la tension d'alimentation de la bobine de balayage vertical d'un récepteur de télévision, le signal de consigne étant un signal sensiblement en dents de scie à la fréquence de balayage vertical.

19. Application du circuit selon l'une quelconque des revendications 1 à 16 à l'alimentation d'un moteur.

20. Application du circuit selon l'une quelconque des revendications 1 à 16 à l'alimentation d'un amplificateur audio-fréquence.

**Claims**

1. An electric circuit for the conversion of a nil average value alternate voltage having a nil value into a direct or variable voltage at a lower frequency comprising : filtering means ($L_S$, $C_F$), a switch (1) controlled so that at each period of the input alternate voltage it is conducting during a time that is in function of the desired output voltage ($V_S$) and disposed upstream of the filtering means ($L_S$, $C_F$), and a control system of the output voltage on the basis of a reference signal ($V_{REF}$) acting on the control of the switch, characterized in that the measurement signal (111) of the control system is the average value of the voltage at the terminals of the switch (1) during a period of the input alternate voltage.

2. Circuit according to claim 1, characterized in that the filtering means is non dissipative and comprises an inductance ($L_3$) and a capacitor ($C_F$), the output voltage being the voltage at the terminals of this capacitor.

3. Circuit according to claim 1 or 2, characterized in that to establish the average value, it comprises an integrator (12) the input of which receives the voltage signal at the terminals of the control switch (1).

4. Circuit according to claim 3, characterized in that it comprises a comparator (11) to compare the output signal of the integrator (12) with the reference signal ($V_{REF}$) and to control the switch (1) in function of the result of the comparison.

5. Circuit according to claim 3 or 4, characterized in that the integrator is returned to zero at each period of alternate voltage.

6. Circuit according to claims 4 and 5, characterized in that the output of the comparator (11) is connected to the control electrode of switch (1) through the intermediary of a shaping circuit (10) comprising an output connected to the input of the return to zero (RAZ) of the integrator (12).

7. Circuit according to any one of claims 3 to 6, characterized in that the integrator comprises a resistance ($R_2$) in series with a capacitor ($C_2$) the output signal of this integrator being constituted by the voltage at the terminals of the capacitor.

8. Circuit according to claims 5 and 7, characterized in that one diode ($D_2$) is in parallel on the resistance ($R_2$) of the integrator so as to discharge the capacitor ($C_2$) discharge the capacitor ($C_2$) at each period of alternate voltage, when switch (TH) is conducting.

9. Circuit according to claim 4, characterized in that the reference voltage being constant, the comparator comprises a Zener diode ($D_Z$) or a diac the characteristic voltage of which represents the desired output voltage.

10. Circuit according to claims 7 and 9, characterized in that the diode ($D_Z$) is connected between an armature of the capacitor ($C_2$) of the integrator and the control electrode of the switch (TH).

11. Circuit according to claims 4 and 7, characterized in that the comparator comprises a unijunction transistor (UTT) the emitter of which receives the voltage at the terminals of the capacitor ($C_2$) of the integrator and a base of which receives the reference voltage (E).

12. Circuit according to claims 4 and 7, characterized in that the comparator comprises a transistor ($T_2$) one electrode of which receives the voltage at the terminals of the capacitor ($C_2$) of the integrator and another electrode receives the reference signal ($V_{REF}$).

13. Circuit according to claims 5 and 7, characterized in that it comprises a transistor ($T_3$) the emitter-collector space of which is in parallel on the capacitor ($C_2$) of the integrator and which is mounted so as to be conducting when the controlled switch (TH) is itself conducting so as to discharge the said capacitor at each period of the alternate voltage.

14. Circuit according to any one of the preceding claims, characterized in that the controlled switch (11) comprises a thyristor (TH) in parallel but in the reverse direction with a diode (D₁).

15. Circuit according to any one of the preceding claims, characterized in that the alternate voltage is a voltage at the frequency of horizontal sweeping in a television receiver.

16. Circuit according to claim 15, characterized in that the alternate voltage is the line return voltage.

17. Circuit according to claim 15 or 16, characterized in that the output voltage is direct and feeds the auxiliary circuits of a television receiver.

18. Circuit according claim 16, characterized in that the output voltage constitutes the supply voltage of the vertical sweeping coil of a television receiver, the order signal being a substantially sawtooth shaped signal at the frequency of vertical sweeping.

19. Application of the circuit according to any one of claims 1 to 16, to the power supply of a motor.

20. Application of the circuit according to any one of claims 1 to 16, to the power supply of an audio-frequency amplifier.


**Ansprüche**


1. Elektrische Schaltung zur Umwandlung einer Wechselspannung mit einem mittleren Wert Null in eine Gleichspannung oder variable mit einem mittleren Wert Null in eine Gleichspannung oder variable Spannung mit niedrigerer Frequenz, die beinhaltet : ein Filtermittel ($L_S$, $C_F$), einen dergestalt gesteuerten Schalter (I), dass dieser bei jeder Periode der Eingangswechselspannung während einer Zeit die von der gewünschten Ausgangsspannung ($V_S$) abhängt Leiter ist und der oberhalb des Filtersmittels ($L_S$, $C_F$) angebracht ist, und eine auf die Steuerung des Schalters einwirkende Vorrichtung zum Steuern der Ausgangsspannung nach einem Sollwert ($V_{REF}$), dadurch gekennzeichnet, dass das Messsignal (11₁) der Steuervorrichtung der Mittelwert der Klemmenspannung des Schalters (1) während einer Periode der Eingangswechselspannung ist.

2. Schaltung nach Anspruch 1, dadurch gekennzeichnet, dass das Filtermittel nicht energievernichtend ist und eine Induktanz ($L_S$) und einen Kondensator ($C_F$) enthält, wobei die Ausgangsspannung die Klemmenspannung dieses Kondensators ist.

3. Schaltung nach Anspruch 1 oder 2, dadurch gekennzeichnet, dass diese zur Erstellung des Mitellwertes einen Integrator (12) enthält, dessen Eingang des Spannungssignal an den Klemmen des gesteuerten Schalters (1) empfängt.

4. Schaltung nach Anspruch 3, dadurch gekennzeichnet, dass diese einen Komparator (11) enthält um das Ausgangssignal des Integrators (12) mit dem Sollwertsignal ($V_{REF}$) zu vergleichen und um den Schalter (1) gemäss dem Vergleichsergebnis zu steuern.

5. Schaltung nach Anspruch 3 oder 4, dadurch gekennzeichnet, dass der Integrator bei jeder Wechselspannungsperiode auf Null zurückgestellt ist.

6. Schaltung nach den Ansprüchen 4 und 5, dadurch gekennzeichnet, dass der Ausgang des Komparators (11) mit der Steuerelektrode des Schalters (1) durch eine Formbildungsschaltung (10) verbunden ist, welcher einen mit dem Nullstellungseingang (RAZ) des Integrators verbundenen Ausgang enthält.

7. Schaltung nach einem der Ansprüche 3 bis 6, dadurch gekennzeichnet, dass der Integrator einen mit einem Kondensator ($C_2$) in Serie geschalteten Widerstand ($R_2$), enthält, wobei das Ausgangssignal dieses Integrators durch die Klemmenspannung des Kondensators gebildet wird.

8. Schaltung nach den Ansprüchen 5 und 7, dadurch gekennzeichnet, dass eine Diode ($D_2$) dergestalt mit dem Widerstand ($R_2$) des Integrators parallel geschaltet ist, dass sie den Kondensator ($C_2$) bei jeder Spannungsperiode der Wechselspannung entlädt, da der Schalter (TH) Leiter ist.

9. Schaltung nach Anspruch 4, dadurch gekennzeichnet, dass der Komparator eine Zenerdiode ($D_Z$) oder Diac enthält, deren Spannung die gewünschte Ausgangsspannung wiedergibt.

10. Schaltung nach den Ansprüchen 7 und 9, dadurch gekennzeichnet, dass die Diode ($D_Z$) zwischen einen Belag des Kondensators ($C_2$) des Integrators und der Steuerelektrode des Schalters (TH) geschaltet ist.

11. Schaltung nach den Ansprüchen 4 und 7, dadurch gekennzeichnet, dass der Komparator einen S-Transistors (UJT) enthält, dessen Emitter die Klemmenspannung ($C_2$) des Integrators empfängt und eine der Basen die Sollspannung (E) empfängt.

12. Schaltung nach den Ansprüchen 4 und 7, dadurch gekennzeichnet, dass der Komparator einen Transistor ($T_2$) enthält, von dem eine Elektrode die Klemmenspannung ($C_2$) des Integrators empfängt und eine andere Elektrode das Sollwertsignal ($V_{REF}$) empfängt.

13. Schaltung nach den Ansprüchen 5 und 7, dadurch gekennzeichnet, dass sie einen Transistor ($T_3$) enthält, dessen Abschnitt Emitter-Kollektor mit dem Kondensator ($C_2$) des Integrators parallel geschaltet ist und der zusammengesetzt ist um Leiter zu sein, da der gesteuerte Schalter (TH) selbst Leiter ist, so dass er den besagten Kondensator bei jeder Wechselspannungsperiode entlädt.

14. Schaltung nach einem der vorangehenden Ansprüche, dadurch gekennzeichnet, dass der gesteuerte Schalter (1) einen parallel, aber umgekehrt mit einer Diode ($D_1$) geschalteten Thyristor (TH) enthält.

15. Schaltung nach einem der vorangehenden Ansprüche, dadurch gekennzeichnet, dass die Wechselspannung eine Spannung mit der Frequenz der horizontalen Abtastung in einem Fernsehempfänger ist.

16. Schaltung nach Anspruch 15, dadurch gekennzeichnet, dass die Wechselspannung die Spannung des Zeilenrücklaufes ist.

17. Schaltung nach Anspruch 15 oder 16, dadurch gekennzeichnet, dass die Ausgangsspannung anhaltend ist und Hilfsschaltungen eines Fernsehempfängers versorgt.

18. Schaltung nach Anspruch 16, dadurch gekennzeichnet, dass die Ausgangsspannung die Versorgungsspannung der Spule eines Fernsehempfängers zur vertikalen Abtastung bildet, wobei das Sollsignal ein in der Frequenz der vertikalen Abtastung spürbar sägezahnförmiges Signal ist.

19. Anwendung der Schaltung nach einem der Ansprüche 1-16 zur Versorgung eines Motors.

20. Anwendung der Schaltung nach einem der Ansprüche 1-16 zur Versorgung eines Tonfrequenzverstärkers.

7

# FIG_1

# FIG_2

FIG_3

FIG_4

FIG_5